# EUROPEAN PATENT APPLICATION

(11) **EP 4 560 860 A1**
(43) Date of publication of application: **28.05.2025**
(21) Application number: 23383187.4
(22) Date of filing: 21.11.2023
(51) Int. Cl.: H02H 3/087, H02H 3/05, H02H 3/20, H02H 3/24

(54) **ELECTRONIC FUSE FOR POWER CIRCUITS OF A VEHICLE**

(71) Applicant: Ficosa Automotive, S.L.U., 08028 Barcelona (ES)
(72) Inventor: FERNÁNDEZ COMESAÑA, Pablo, 08028 Barcelona (ES); MARSAL ROIG, Marc, 08028 Barcelona (ES)
(74) Representative: Balder IP Law, S.L.

(57) **Abstract**

The invention refers to an electronic fuse for power circuits of a vehicle, the electronic fuse comprising: an input port and an output port, at least two semiconductor switching devices connected in series or in parallel, between the input port and the output, and a control circuit configured to provide a control signal for triggering the electronic fuse. The control circuit is adapted to generate the control signal based on voltage and/or current measurements at the input port or at the input port and the output port. Additionally, the electronic fuse includes a driver device for switching on and off the at least two semiconductor switching devices, based on the control signal, so that, the at least two semiconductor switching devices can be switched on and off at the same time.

## Description

### TECHNICAL FIELD

The present invention relates to an electronic fuse to protect power circuits against over-currents or over-voltages.

An object of the invention is to provide an electronic fuse that features: reduced size, fast actuation, longer life span, and that can be easily configured to comply with desired security requirement.

The use of the electronic fuse of the invention, is especially advantageous in vehicles in general, and more particularly in electric or hybrid vehicles.

### STATE OF THE ART

Traditionally, protection of electronic circuits and equipment against over-currents or over-voltages, has been implemented by thermal fuses and electromechanics relays, which are bulky, have a reduced life span, and a react slowly for certain applications.

Furthermore, a traditional thermal fuse is a single-use protection device that once blow off, it has to be manually replaced by a new fuse.

Electronic fuses provide the significant advantage of being reusable, and usually have a faster respond compared with thermal fuses.

As the demand for small sized devices, especially in the automobile industry, continues to grow, so does the demand for electronic fuses with improved features.

### DESCRIPTION OF THE INVENTION

The invention refers to an electronic fuse for power circuits of a vehicle, preferably for power circuits operating up to 60 Volts and currents up to 250 A.

The electronic fuse of the invention comprises: an input port and an output port, and at least two semiconductor switching devices connected in series or in parallel, between the input port and the output port, and a control circuit configured to provide a control signal for triggering the electronic fuse, that is, for switching On/Off the semiconductor switching devices. In a practical implementation of the invention, the input and output ports are used to connect the electronic fuse in an electronic circuit.

The control circuit is adapted to generate the control signal based on voltage and/or current measurements at the input port or at the input port and the output port.

The electronic fuse further comprises a driver device for switching On and Off the at least two semiconductor switching devices, based on the control signal, so that, the at least two semiconductor switching devices can be switched On and Off at the same time.

In a preferred embodiment, the electronic fuse comprises two, three or more branches connected in parallel between the input port and the output port, each branch including at least one semiconductor switching device. Preferably, each branch has two semiconductor switching devices connected in series.

The two semiconductor switching devices of each branch, are connected to allow current circulation only in the same direction within the branch in which they are connected. Alternatively, the two semiconductor switching devices of each branch, are connected to allow current circulation in opposite directions within the branch in which they are connected.

Each semiconductor switching device is a solid-state switch, preferably a MOSFET transistor with an antiparallel diode connected to it in a known manner.

In a preferred embodiment, the control circuit includes a first comparator connected to compare a voltage measurement at the input or output port with a reference voltage, the control signal being the output of the first comparator which is supplied to the driver. The control circuit may include a second comparator connected to compare a voltage measurement at the input or output port, different than the first comparator, with a reference voltage, the control signal being a combination of the output of the first and second comparators, which is supplied to the driver, so the driver would trigger the electronic fuse, that is, it would open the semiconductor switching devices, if one or both of the voltage measurements at the input and output ports, are above the respective threshold voltages.

The control circuit may include a third comparator connected to compare a current measurement at the input or output port with a reference current, the control signal being the output of the third comparator which is supplied to the driver.

In other preferred embodiment, the control circuit includes the first and the third comparators previously described, the control signal being a combination of the output of the first comparator and the output of the third comparator, which is supplied to the driver, so that if one or both of the outputs are positive then the control signal instruct the driver to trigger the electronic fuse.

In other preferred embodiment, the control circuit includes the first, second and third comparators previously described, the control signal being a combination of the output of the first comparator, the output of the second comparator, and the output of the third comparator.

Optionally, the control circuit may include a fourth comparator connected to compare a current measurement at the output or input port, different than the first comparator with a reference current, wherein the control signal is the combination of the outputs of the first to fourth comparators.

The control circuit may be implemented by a microcontroller instead of comparators, and in this case the microcontroller is programmed to provide the control signal based on voltage and/or current measurements at the input port or at the input port and the output port. The microcontroller carries out the comparation function, and provides a command signal for a driver which switches On and Off the MOSFET's.

Preferably, the electronic fuse includes a communication port for communicating the electronic fuse with an Electronic Control Unit, ECU, of a vehicle, the driver being adapted to trigger the electronic fuse based also in a signal received at the communication port.

Another aspect of the invention refers to a Power Distribution Unit, PDU, for a vehicle, incorporating the above defined electronic fuse.

Another aspect of the invention refers to an Electronic Control Unit, ECU, for a vehicle, incorporating the above defined electronic fuse.

Some of the advantages of the invention are the followings:
- fast failure protection reaction (less than 50us) and diagnostic;
- controlled over current protection (configurable time and current);
- under and/or over voltage protection in primary power Distribution, PD unit;
- in the event of failure, definition of safety state (close/open switch);
- extra functions like battery resistance measurement can be performed by a Power Electronics Switch.
- bidirectional Current monitoring;
- communication interface (CAN comms), to send driver status to other ECU;
- redundancy on measurements;
- redundancy in the comparison to open/close the switch;
- redundancy on Mosfets to ensure that the safety state can be achieved independently of a Mosfet failure (avoid single point faults);
- fast MOSFET actuation in the range of nanoseconds;
- resettable protection;
- voltage, current and temperature protection;
- accurate current protection setting.

### BRIEF DESCRIPTION OF THE DRAWINGS

To complete the description and in order to provide a better understanding of the invention, a set of drawings is provided. These drawings form an integral part of the description and illustrate embodiments of the invention, which should not be interpreted as restricting the scope of the invention, but just as examples of how the invention can be carried out. The drawings comprise the following figures:
Figure 1.- shows an electric diagram of an electronic fuse according to the invention, using comparators to generate the control signal.
Figure 2.- shows an electric diagram of an electronic fuse according to the invention, using a microcontroller to generate the control signal.
Figures 3 and 4.- shows two electric diagrams of two alternative embodiment of the electronic fuse of the invention.
Figure 5.- shows two alternative electric connection of semiconductor switching devices. In Figure 5A the current can be blocked in both directions of flow, and in Figure 5B the current can flow in both directions, but it can only be blocked in one direction.
Figure 6.- shows an electric diagram of the electric connection between a driver and two semiconductor switching devices.

### PREFERRED EMBODIMENTS OF THE INVENTION

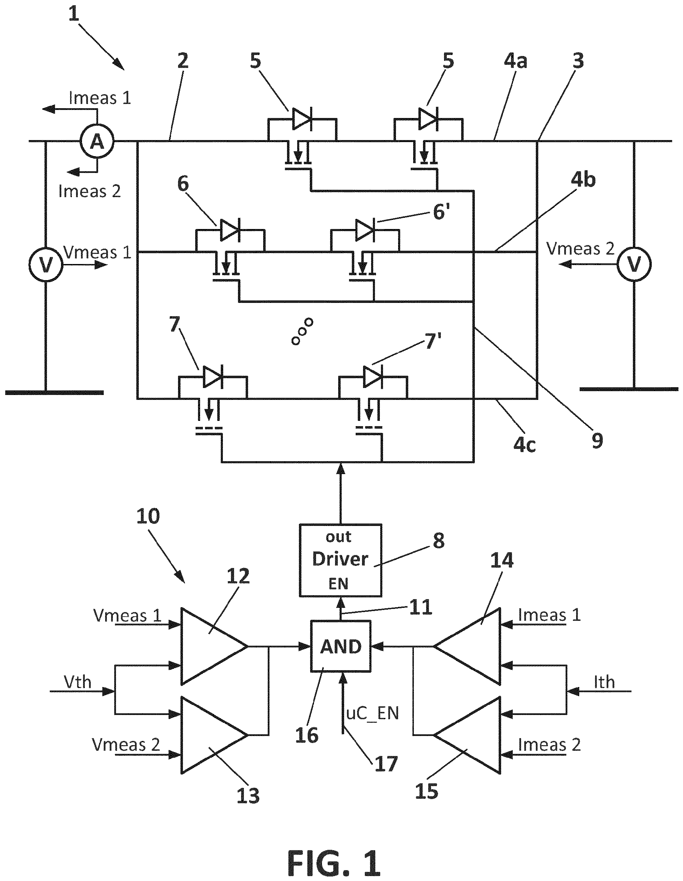

**Figure 1** shows an exemplary embodiment of an electronic fuse (1) according to the invention, that comprises an input port (2) and an output port (3), and three branches (4a,4b,4c) connected in parallel between the input and output ports (2,3), wherein each branch (4a,4b,4c) includes two semiconductor switching devices (5,5',6,6',7,7') - in this example embodied as a MOSFET transistor with an antiparallel diode connected to it - connected in series within the respective branch.

The pairs of semiconductors switching devices (5,5',6,6',7,7') are in turn connected in parallel, so that a current circulating between the input port (2) to the output port (3) would be split up in three paths. This means that each branch (4a,4b,4c) has to be calculated for the circulation and for interrupting 1/3 of the nominal current which is expected to flow between the input and output ports in normal operation of a particular circuit.

The electronic fuse (1) further includes a driver (8) for switching on and off all the semiconductor switching devices (5,5',6,6',7,7') at the same time, and for that, the gate terminal of each semiconductor switching device, is connected with an output of the driver (8) by means of a line (9). The driver must be able to supply directly or indirectly, e.g. via one/several capacitor(s), the required current (I) or voltage (V) of all semiconductors at the same time.

The driver (8) operates for triggering the electronic fuse, based on a control signal supplied by a control circuit (10) which in turn is configured to generate the control signal based on voltage and/or current measurements at the input port or at the input port and the output port.

Preferably, the driver (8) is a high side driver because the source terminal of the MOSFET is floating, that is, is not referenced to ground. Additionally, the driver (8) must supply and absorb the necessary current to turn on/off all the MOSFETS of the electronic fuse at the same time in the required time.

In the embodiment of **Figure 1****,** the control circuit (10) includes a first comparator (12) connected to compare a voltage measurement (Vmeas1) taken at the input port (2) with a reference voltage (Vth), and a second comparator (13) connected to compare a voltage measurement at the output port (3) with the same reference voltage (Vth). Furthermore, the control circuit (10) includes a third comparator (14) connected to compare a current measurement (Imeas1) at the input port (2) with a reference current (Ith), and a fourth comparator (15) connected to compare a second current measurement (Imeas2) also at the input port (2) with the same reference current (Ith). Optionally, temperature could also be measured.

The outputs of the first, second, third and fourth comparators (12) are fed to an AND gate (16), which generates the control signal (11) for the driver (8), so that if all the outputs of the comparators are positive, then, the control signal would instruct the driver (8) to trigger the electronic fuse.

Alternatively, instead of an AND gate, an OR gate can be used so in this case if at least one of the comparators outputs is positive, then, the control signal would activate the driver to trigger the electronic fuse.

Additionally, the electronic fuse may include a communication port (17) for communicating the electronic fuse with an Electronic Control Unit, ECU, of a vehicle, the driver (8) being adapted to trigger the electronic fuse based also in a signal received at the communication port. In the practical example of **Figure 1****,** the communication port (17) is an input of the AND gate (16).

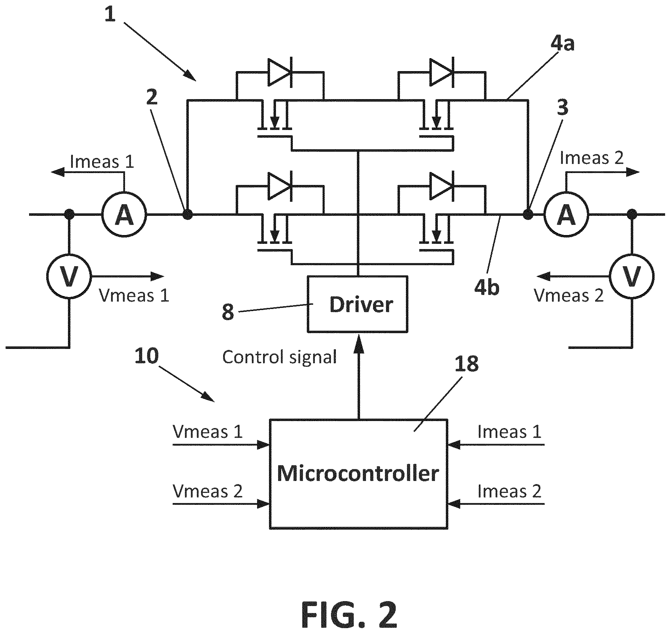

In the alternative embodiment of **Figure 2****,** instead of comparators, the control circuit is realized as a microcontroller (18) configured to provide the control signal based also on voltage and/or current measurements at the input port (2) or at the input and the output ports (2,3).

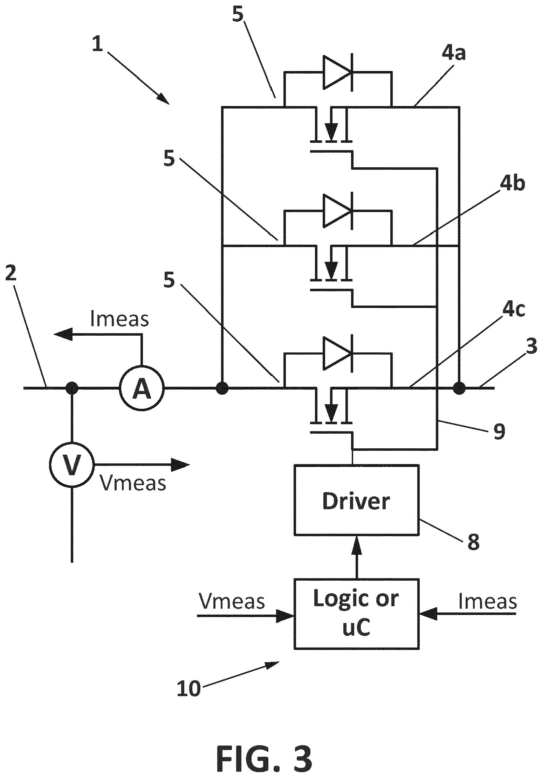

In the embodiment of **Figure 3****,** the electronic fuse (1) has also three branches (4a,4b,4c) connected in parallel, but each branch has only one semiconductor switching device (5). The control circuit (10) can be implemented with comparators as described in relation with **Figure 1****,** or with a microcontroller as described in relation with **Figure 2****.**

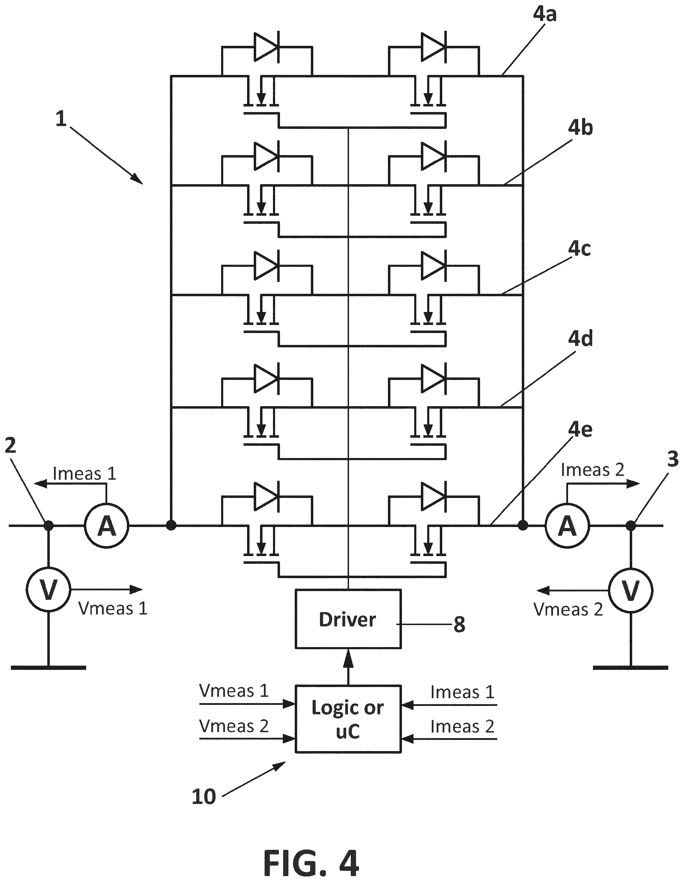

In the embodiment of **Figure 4****,** the electronic fuse (1) has five branches (4a,4b,4c,4d,4e) connected in parallel, each branch having two semiconductor switching devices (5) connected in series in the branch. The control circuit (10) can be implemented with comparators as described in relation with **Figure 1****,** or with a microcontroller as described in relation with **Figure 2****.**

It can be noted from the embodiments of **Figures 3** and **4**, that the configuration of the electronic fuse (1) can be easily scaled or adapted to comply with the security requirements of each particular application.

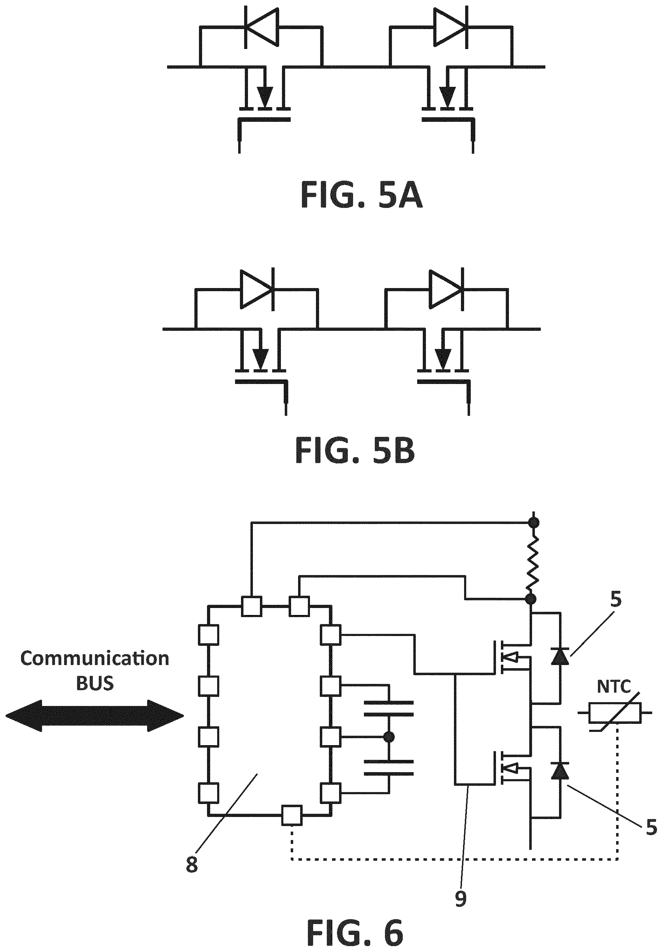

In all the above-described embodiments having two semiconductor switching devices in each branch, the two switches are connected to allow current circulation in the same direction within the branch in which they are connected, as shown in **Figure 5B**.

Alternatively, the two switches can be connected to allow current circulation in opposite directions within the branch in which they are connected, as shown in **Figure 5A****.**

A particular implementation of the driver (8) is shown in **Figure 6****,** which is an Automobile Safety Integrity Level, ASIL, compatible driver, capable of Current protection, Voltage protection and temperature protection, and including a communication BUS to transmit the driver status to other ECU's.

Preferably, the driver is a high side driver because the source terminal of the MOSFET's is floating, that is, it is not referenced to ground of the circuit, as in this case, because after the source terminal there is another semiconductor or the load to be powered.

Additionally, the high side driver has to be isolated in order to isolate the circuit that feeds the driver itself from the circuit where the semiconductors are located. The isolation can be, for example, galvanic isolation or bootstrap circuits for the isolation of both circuits.

The driver should supply and absorb the necessary current to turn On/Off all the MOSFET's of the system in the required time. The driver shall manage "n" times "I", where "n" is the number of MOSFET's and "I" the current consumption of each one. A parallel capacitor can be used to help the driver to achieve the peak current to turn On/Off of MOSFET's.

As high currents must be conducted through a Printed Circuit Board, PCB, a heavy copper PCB is used for the implementation of the electronic fuse, which incorporates copper inserts (inlay) of a considerable thickness in the internal layers. There are different types of PCBs for high currents:
- Metal inlay technology having an inlay thickness of min 0.5mm any dimension;
- Heavy copper technology having an inlay thickness of at least 100um, preferably above 250um, and more preferably above 500um.

Any other technology with similar or better working characteristics and with the above-mentioned thickness ranges, could also be used.

These thick inlays allow high currents conduction without overheating, and help to dissipate heat by conduction, because they have a large surface to exchange heat with the ambient air.

Therefore, the PCB incorporates in its top layer: the driver, the logic circuitry or the microcontroller, and the MOSFET's, and the thick inlays in internal layers.

The electronic fuse of the invention can be implemented in several practical applications, such as:
- as part of a Primary Power Distribution Unit, which is in charge of the protection and distribution of power from the Low-Voltage battery to each of the Low-Voltage consumers of a vehicle. This embodiment usually consists of a set of electronic fuses, individual current sensors for each of the auxiliary power-line. Typically, these are Low Voltage - High current applications;
- as part of a low-voltage Electronic Control Unit, ECU, of a vehicle providing protection at the power inlet of the ECU;
- as a protection system included in the auxiliary lines of a JBOX. This application is usually, High-Voltage Low-Current.

## Claims

1. Electronic fuse (1) for power circuits of a vehicle, the electronic fuse comprising:
an input port (2) and an output port (3),
at least two semiconductor switching devices (5,5') connected in series or in parallel, between the input and output ports (2,3),
a control circuit (10) configured to provide a control signal (11) for triggering the electronic fuse, wherein the control circuit (10) is adapted to generate the control signal based on voltage and/or current measurements at the input port (2) or at the input and output ports (2,3),
a driver (8) for switching On and Off the at least two semiconductor switching devices (5), based on the control signal (11), so that, the at least two semiconductor switching devices (5) can be switched On and Off at the same time.

2. Electronic fuse according to claim 1, further comprising two, three or more branches (4a,4b,4c) connected in parallel in between the input and output ports (2,3), each branch including at least one semiconductor switching device (5,5').

3. Electronic fuse according to claim 2, wherein each branch (4a,4b,4c) has two semiconductor switching devices (5,5') connected in series.

4. Electronic fuse according to claim 3, wherein the two semiconductor switching devices (5,5') of each branch (4a,4b,4c), are connected to allow current circulation in the same direction within the branch in which they are connected.

5. Electronic fuse according to claim 3, wherein the two semiconductor switching devices (5,5') of each branch (4a,4b,4c), are connected to allow current circulation in opposite directions within the branch in which they are connected.

6. Electronic fuse according to any of the preceding claims, wherein each semiconductor switching device (5,5') is formed by a MOSFET transistor with an antiparallel diode connected to the MOSFET transistor.

7. Electronic fuse according to any of the preceding claims, wherein the control circuit (10) includes a first comparator (12) connected to compare a voltage measurement at the input or output port (2,3) with a reference voltage, wherein the control signal (11) is the output of the first comparator which is supplied to the driver (8).

8. Electronic fuse according to claim 7, wherein the control circuit (10) includes a second comparator (13) connected to compare a voltage measurement at the input or output port 2,(3) different than the first comparator (12) with a reference voltage, wherein the control signal (11) is a combination of the output of the first and second comparators (12,13), which is supplied to the driver (8), so that if one output or both of them are positive then the control signal (11) instructs the driver (8) to trigger the electronic fuse.

9. Electronic fuse according to any of the claims 1 to 8, wherein the control circuit (10) includes a third comparator (14) connected to compare a current measurement at the input or output port (2,3) with a reference current, wherein the control signal (11) is the output of the third comparator (14) which is supplied to the driver (8).

10. Electronic fuse according to any of the claim 7, wherein the control circuit (10) includes a third comparator (14) connected to compare a current measurement at the input or output port (2,3) with a reference current, wherein the control signal (11) is a combination of the output of the first comparator (14) and the output of the third comparator (14), which is supplied to the driver (8), so that if both outputs or one of them is positive then the control signal (11) instructs the driver (8) to trigger the electronic fuse.

11. Electronic fuse according to any of the claim 8, wherein the control circuit (10) includes a third comparator (14) connected to compare a current measurement at the input port or output port (2,3) with a reference current, the control signal (11) being a combination of the output of the first comparator (12), the output of the second comparator (13), and the output of the third comparator (14), wherein the control signal (11) is supplied to the driver (8), so that if one of the outputs is positive, then the control signal (11) instructs the driver (8) to trigger the electronic fuse.

12. Electronic fuse according to any of the preceding claims, including a communication port (17) for communicating the electronic fuse with an Electronic Control Unit, ECU, of a vehicle, the driver (8) being adapted to trigger the electronic fuse based also in a signal received at the communication port (17).

13. Electronic fuse according to any of the claims 1 to 6, wherein the control circuit (10) comprises a microcontroller (18) configured to provide the control signal (11) based on voltage and/or current measurements at the input port (2) or at the input and output ports (2,3).

14. Electronic fuse according to any of the preceding claims, incorporating a Printed Circuit Board, PCB, including thick copper inlays in its internal layers, wherein the semiconductor switching devices (5,5') are connected by means of these thick copper inlays, and wherein the thickness of the thick inlays is at least 100um, or preferably above 250um, or more preferably above 500um.

15. An Electronic Control Unit, ECU, for a vehicle, incorporating the electronic fuse (1) defined in any of the preceding claims 1 to 14.
